# EUROPEAN PATENT APPLICATION

(11) **EP 1 843 411 A1**
(43) Date of publication of application: **10.10.2007**
(21) Application number: 06112219.8
(22) Date of filing: 04.04.2006
(51) Int. Cl.: H01L 51/52

(54) **System for displaying images including electroluminescent device and method for fabricating the same**

(71) Applicant: Toppoly Optoelectronics Corp., 350 Chu-Nan, Miao-Li Country (TW)
(72) Inventor: Hsu, Hisang-Lun, 360, Miaoli County (TW)
(74) Representative: Patentanwälte Kewitz & Kollegen

(57) **Abstract**

Systems for displaying images and fabrication method thereof are provided. A representative system incorporates an electroluminescent device that includes a substrate, an anode formed on the substrate, a plurality of electroluminescent layers formed on the anode, an electron injection layer formed on the electroluminescent layers, and a cathode formed directly on the electron injection layer. Particularly, the electron injection layer can be a lanthanide-containing layer or actinide-containing layer.

## Description

### BACKGROUND

The present invention relates to an electroluminescent device and a method for fabricating the same and, more particularly, to an electroluminescent device having an improved efficiency in injecting electrons from a cathode to electroluminescent layers and fabrication method thereof.

Recently, with the development and wide application of electronic products such as mobile phones, personal digital assistants, and notebook computers, there has been an increased demand for flat display devices which consume less power and occupy less space. Organic electroluminescent devices are self-emitting and highly luminous, have a wider viewing angle, faster response, and a simple fabrication process, making them an industry display of choice.

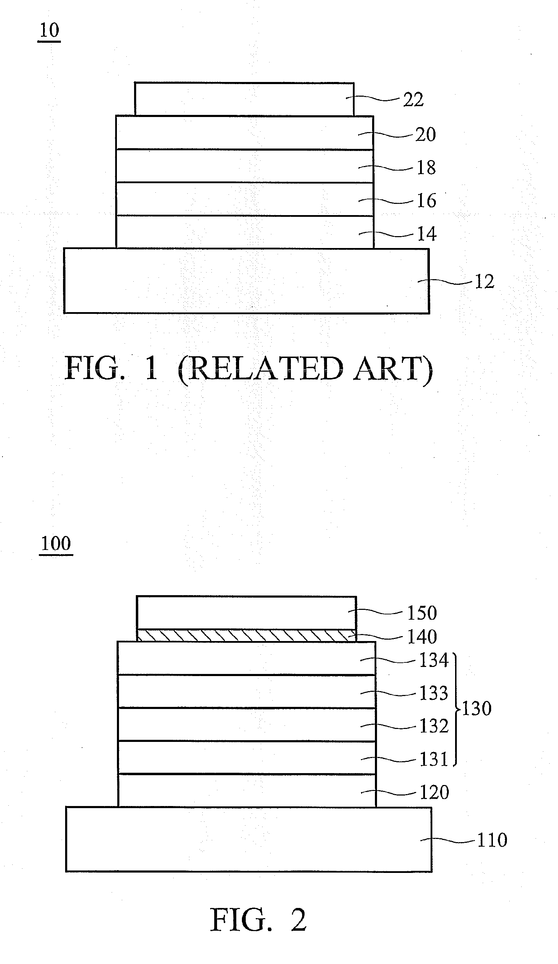

As shown in Fig. 1, an organic electroluminescent device 10 is basically configured such that an anode 14 is formed on a substrate 12, and a hole transport layer 16, an emitter layer 18, an electron transport layer 20, and a cathode 22 are sequentially stacked on the anode 14. Here, the hole transport layer 16, the emission layer 18 and the electron transport layer 20 are organic layers made of organic materials.

In organic electroluminescence, electrons are propelled from the cathode and holes from the anode, and the applied electric field induces a potential difference, such that the electrons and holes move and centralize in the emission layer via the electron or hole transport layer respectively, resulting in luminescence through recombination thereof. The recombination takes place within the emission layer at a region near the interface between the emission layer and the hole transport layer (or the electron transport layer) to generate excitons. The generated excitons de-excite from an excited state to a ground state to emit light, thus forming an image.

In order to improve a low driving voltage characteristic and charge balance between electrons and holes, it is necessary to increase an efficiency in injecting electrons from the cathode into the electron transport layer. Conventional methods for increasing such injection efficiency have been proposed in U. S. Pat. Nos. 5, 429, 884, 5, 059, 862 and 4, 885, 211, describing use of an alkali metal having a low work function, e.g., lithium or magnesium, codeposition of an alkali metal and a metal such as aluminum or silver, and use of alloys of an alkali metal and a metal such as aluminum or silver, respectively. Since the metal that has a low work function is very unstable and highly reactive, use of the metal, however, is disadvantageous in view of the processability and the stability of EL device.

Other techniques for increasing the electron injection efficiency have been proposed in U.S. Pat. Nos. 5,776,622, 5,776,623, 5,937,272 and 5,739,635, and Appl. Phy Lett. 73 (1998) P.1185, in which an electron injection layer containing inorganic materials such as LiF, CsF, SrO or Li₂O, is formed between the cathode and the electron transport layer with a thickness of 5~20Å.

Recently, another method for increasing electron injection efficiency has been proposed in which a metal alkylate or metal arylate, such as CH₃COOLi or C₆H₅COOLi, is formed between the cathode and the electron transport layer. This method is also problematic in that it is difficult to form a thin film having a uniform thickness of 5~40Å, which is not suitable for large-area deposition.

Thus, in order to enhance luminescent efficiency, an active matrix organic electroluminescent device having improved efficiency in injecting electrons from a cathode to electroluminescent layers is called for.

### SUMMARY

Systems for displaying images are provided. In this regard, an exemplary embodiment of such as system comprises an organic electroluminescent device, comprising a substrate, an anode formed on the substrate, a plurality of electroluminescent layers formed on the anode, an electron injection layer formed on the electroluminescent layers, and a cathode formed directly on the electron injection layer. The electron injection layer can be a lanthanide-containing layer or actinide-containing layer.

Methods for fabricating the system for displaying images are also provided, in which a substrate is provided. An anode, electroluminescent layers, an electron injection layer, and a cathode are sequentially formed on the substrate, wherein the electron injection layer comprises a lanthanide-containing layer or actinide-containing layer. The electron injection layer is directly formed on the cathode.

A detailed description is given in the following with reference to the accompanying drawing.

### BRIEF DESCRIPTION OF THE DRAWINGS

The invention can be more fully understood by reading the subsequent detailed description in conjunction with the examples and references made to the accompanying drawings, wherein:
Fig. 1 shows a cross section of a conventional electroluminescent device.
Fig. 2 shows a cross section of an electroluminescent device according to embodiments of the invention.
Fig. 3 shows a graph plotting operating voltage against current density of the electroluminescent device (1) as disclosed in Example 1.
Fig. 4 shows a graph plotting operating voltage against brightness of the electroluminescent device (1) as disclosed in Example 1.
Fig. 5 shows a graph plotting operating voltage against current density of the electroluminescent devices as disclosed in Examples 2~4.
Fig. 6 shows a graph plotting operating voltage against brightness of the electroluminescent devices as disclosed in Examples 2~4.
Fig. 7 shows a graph plotting operating voltage against efficiency of the electroluminescent devices as disclosed in Examples 2~4.
Fig. 8 schematically shows another embodiment of a system for displaying images

### DETAILED DESCRIPTION

The invention uses an electron injection layer to facilitate injection of electrons into electroluminescent layers from a cathode.

Fig. 2 shows an embodiment of a system for displaying images that includes an electroluminescent device 100. According to one embodiment, the electroluminescent device 100 comprises a substrate 110, an anode 120, electroluminescent layers 130, an electron injection layer 140, and a cathode 150, as shown in Fig. 2. The substrate 110 can be glass or plastic. Suitable material for the anode 120 is transparent metal or metal oxide, such as indium tin oxide (ITO), indium zinc oxide (IZO), aluminum zinc oxide (AZO), or zinc oxide (ZnO), formed by sputtering, electron beam evaporation, thermal evaporation, or chemical vapor deposition.

The electroluminescent layers 130 may comprise a hole injection layer 131, a hole transport layer 132, an emission layer 133, and an electron transport layer 134, including organic semiconductor materials, such as small molecule materials, polymer, or organometallic complex, formed by thermal vacuum evaporation, spin coating, dip coating, roll-coating, injection-filling, embossing, stamping, physical vapor deposition, or chemical vapor deposition. The thickness of each layer is not particularly limited, but if too thick, a large applied voltage is required to obtain a fixed light output, thus reducing efficiency. On the other hand, if it is too thin, pin-holes are generated. The thickness of each of the layers 131, 132, 133, and 134 is preferably of 1nm to 1µm.

Particularly, the electron injection layer 140 comprises a lanthanide-containing layer or actinide-containing layer, formed between the electroluminescent layers 130 and the cathode 150, 0.1~5nm thick, preferably 0.1~1nm thick. The actinide-containing layer may comprise actinide fluoride, actinide chloride, actinide bromide, actinide oxide, actinide nitride, actinide sulfide, actinide carbonate, or combinations thereof, and the lanthanide-containing layer may comprise lanthanide fluoride, lanthanide chloride, lanthanide bromide, lanthanide oxide, lanthanide nitride, lanthanide sulfide, lanthanide carbonate, or combinations thereof. Wherein, the lanthanide or actinide element may be selected from the group of elements consisting of Ce, Pr, Nd, Sm, Eu, Gd, Tb, Dy, Ho, Er, Tm, Yb, Lu, and U. For example, in embodiments of the invention, the electron injection layer 140 can be cerium halide (such as CeF₃ or CeF₄), cerium nitride, cerium oxide, cerium sulfide, cerium oxyfluoride, cerium carbonate, or combinations thereof.

The cathode 150 can be capable of injecting electrons into the electroluminescent layer 130 via the electron injection layer 140, for example, a low work function material such as Ca, Ag, Mg, Al, Li, or alloys thereof, formed by sputtering, electron beam evaporation, thermal evaporation, or chemical vapor deposition.

The following examples are intended to illustrate the invention more fully without limiting their scope, since numerous modifications and variations will be apparent to those skilled in this art.

### Example 1

A glass substrate with an indium tin oxide (ITO) film of 100 nm was provided and then washed by a cleaning agent, acetone, and isopropanol with ultrasonic agitation. After drying with nitrogen flow, the ITO film was subjected to uv/ozone treatment. Next, a hole transport layer, light-emitting layer, electron transport layer, electron injection layer, and aluminum electrode were subsequently formed on the ITO film at 10⁻⁵Pa, obtaining the electroluminescent device (1). For purposes of clarity, the materials and layers formed therefrom are described in the following.

The hole transport layer, with a thickness of 150nm, consisted of NPB (N,N'-di-1-naphthyl-N,N'-diphenyl-1,1'-biphenyl-1,1'-biph enyl-4,4'-diamine). The light-emitting layer 18, with a thickness of 40nm, consisted of C545T (10-(2-Benzothiazolyl)-2,3,6,7-tetrahydro-1,1,7,7-tetramethyl-1H,5H,11H-(1)-benzopyropyrano(6,7-8-i,j)quinolizin-11-one) as dopant, and Alq₃ (tris (8-hydroxyquinoline) aluminum) as light-emitting material host, wherein the weight ratio between Alq₃ and dopant was 100:1. The electron transport layer, with a thickness of 10nm, consisted of BeBq2 (bis(10-hydroxybenzo[h]quinolinato)beryllium). The electron injection layer, with a thickness of 1nm, consisted of cerium fluoride (CeF₄).

The emissive structure of the electroluminescent device (1) can be represented as below:
ITO 100nm/NPB 150nm/Alq₃:C545T 100:1 40nm/BeBq₂ 30nm/CeF₄ 10Å/Al 150nm

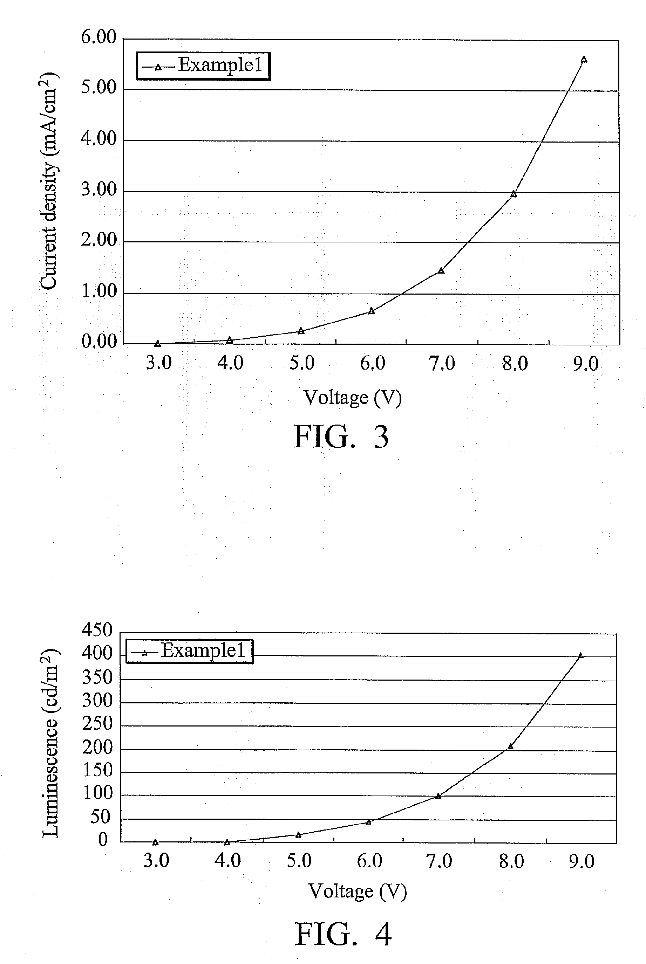

The optical property of electroluminescent device (1), as described in Example 1, was measured by PR650 (purchased from Photo Research Inc.) and Minolta TS110. Fig. 3 illustrates a graph plotting operating voltage against current density of the electroluminescent device (1), and Fig. 4 a graph plotting operating voltage against brightness.

### Example 2

A glass substrate with an indium tin oxide (ITO) film of 100 nm was provided and then washed by a cleaning agent, acetone, and ethanol with ultrasonic agitation. After drying with nitrogen flow, the ITO film was subjected to uv/ozone treatment. Next, a hole injection layer, hole transport layer, light-emitting layer, electron transport layer, electron injection layer, and aluminum electrode were subsequently formed on the ITO film at 10⁻⁵ Pa, obtaining the electroluminescent device (2). For purposes of clarity, the materials and layers formed therefrom are described in the following.

The hole injection layer, with a thickness of 5nm, consisted of LGC101 (purchased by LG Chem, Ltd.). The hole transport layer, with a thickness of 150nm, consisted of NPB (N,N'-di-1-naphthyl-N,N'-diphenyl-1,1'-biphenyl-1,1'-biph enyl-4,4'-diamine). The light-emitting layer 133, with a thickness of 40nm, consisted of C545T (10-(2-Benzothiazolyl)-2,3,6,7-tetrahydro-1,1,7,7-tetramethyl-1H,5H,11H-(1)-benzopyropyrano(6,7-8-i,j)quinolizin-11-one) as dopant, and Alq₃ (tris (8-hydroxyquinoline) aluminum) as light-emitting material host, wherein the weight ratio between Alq₃ and dopant was 100:1. The electron transport layer, with a thickness of 10nm, consisted of BeBq2 (bis(10-hydroxybenzo[h]quinolinato)beryllium). The electron injection layer, with a thickness of 0.3nm, consisted of cerium fluoride (CeF₄).

The emissive structure of the electroluminescent device (2) can be represented as below:
ITO 100nm/LG101 5nm/NPB 150nm/Alq₃:C545T 100:1 40nm/BeBq₂ 30nm/CeF₄ 3Å/Al 150nm

### Examples 3~4

Examples 3 and 4 were performed as Example 2 except that the thickness of the cerium flouride was increased to 0.5nm and 1nm, respectively.

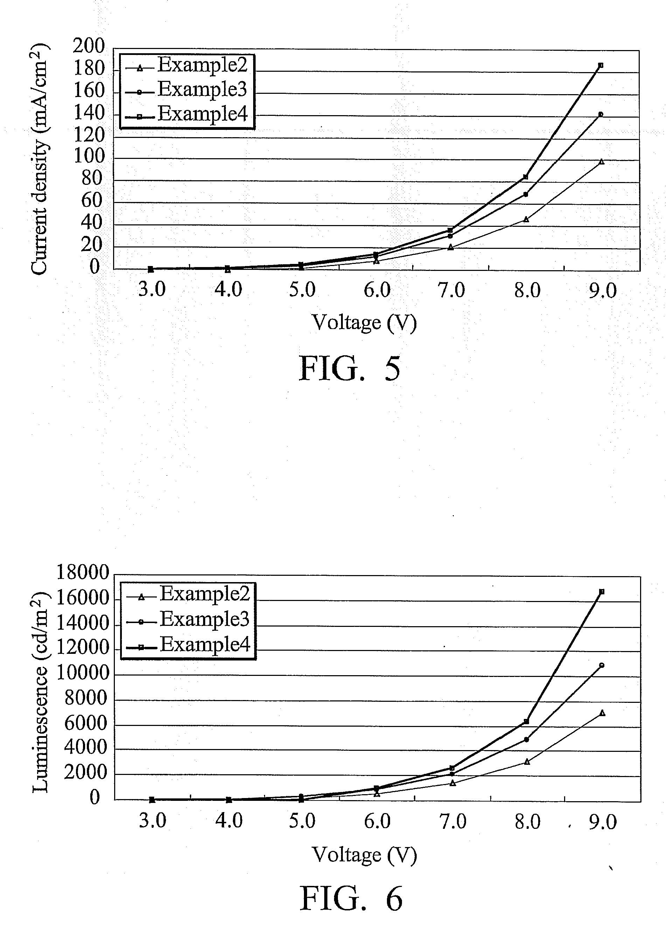

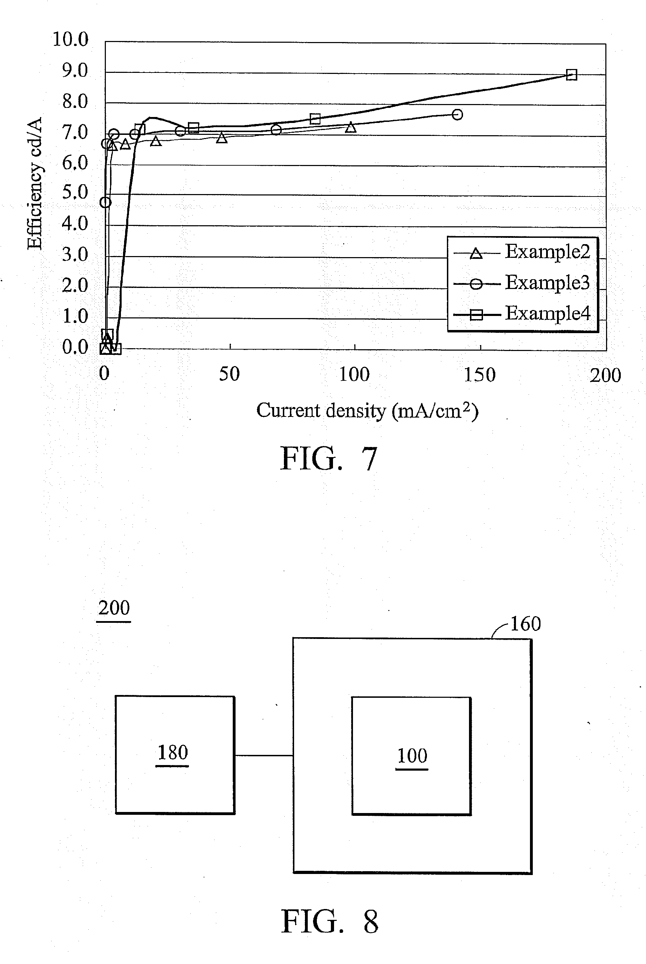

Figs. 5~7 also illustrate the differences between properties for the electroluminescent devices as described respectively in Examples 2~4. In Figs. 5~7, the electroluminescent device, with a 10 Å thick cerium fluoride layer, disclosed in Example 4 has lower operating voltages and higher efficiency.

Fig. 8 schematically shows an embodiment of a system for displaying images which, in this case, is implemented as a display device 160 or an electronic device 200. The described organic electroluminescent device 100 can be incorporated into a display panel that can be an OLED panel. As shown in Fig. 8, the display panel 160 comprises an electroluminescent device, such as the electroluminescent device 100 shown in Fig. 2. The display panel 160 can form a portion of a variety of electronic devices. Generally, the system for displaying images, such as electronic device 200, can comprise the display panel 160 and an input unit 180. Further, the input unit 180 is operatively coupled to the display panel 160 and provides input signals (e.g., an image signal) to the display panel 160 to generate images. The electronic device 200 can be a mobile phone, digital camera, personal digital assistant, notebook computer, desktop computer, television, car display, or portable DVD player, for example.

While the invention has been described by way of example and in terms of preferred embodiment, it is to be understood that the invention is not limited thereto. It is therefore intended that the following claims be interpreted as covering all such alteration and modifications as fall within the true spirit and scope of the invention.

## Claims

1. A system for displaying images, comprising:
an electroluminescent device, comprising:
a substrate;
an anode formed on the substrate;
electroluminescent layers formed on the anode;
an electron injection layer formed on the electroluminescent layers, wherein the electron injection layer comprises a lanthanide-containing layer or actinide-containing layer; and
a cathode formed directly on the electron injection layer.

2. The system as claimed in claim 1, wherein the electron injection layer has a thickness of 0.1~5nm.

3. The system as claimed in claim 1 or 2, wherein the electroluminescent layers comprise a hole transport layer, an emission layer, and an electron transport layer.

4. The system as claimed in any of the preceding claims, wherein the electron injection layer is formed between the electron transport layer and the cathode.

5. The system as claimed in any of the preceding claims, wherein the actinide-containing layer comprises actinide fluoride, actinide chloride, actinide bromide, actinide oxide, actinide nitride, actinide sulfide, actinide carbonate, or combinations thereof.

6. The system as claimed in any of the preceding claims, wherein the lanthanide-containing layer comprises lanthanide fluoride, lanthanide chloride, lanthanide bromide, lanthanide oxide, lanthanide nitride, lanthanide sulfide, lanthanide carbonate, or combinations thereof.

7. The system as claimed in any of the preceding claims, wherein the electron injection layer comprises cerium halide, cerium nitride, cerium oxide, cerium sulfide, cerium oxyfluoride, cerium carbonate, or combinations thereof.

8. The system as claimed in any of the preceding claims, wherein the electron injection layer comprises CeF₃, CeF₄, or combinations thereof.

9. The system as claimed in claim 1, further comprising a display panel, wherein the electroluminescent device forms a portion of the display panel.

10. The system as claimed in any of the preceding claims, further comprising an electronic device, wherein the electronic device comprises:
the display panel; and
an input unit coupled to the display panel and operative to provide input to the display panel such that the display panel displays images.

11. The system as claimed in claim 10, wherein the electronic device is a mobile phone, digital camera, PDA (personal digital assistant), notebook computer, desktop computer, television, car display, or portable DVD player.

12. A method of fabricating a system for displaying images, wherein the system comprising an electroluminescent device, the method comprising:
providing a substrate; and
sequentially forming an anode, electroluminescent layers, an electron injection layer, and a cathode on the substrate, wherein the electron injection layer comprises a lanthanide-containing layer or actinide-containing layer.

13. The method as claimed in claim 12, wherein the electron injection layer has a thickness of 0.1~5nm.

14. The method as claimed in claim 12 or 13, wherein the electroluminescent layers comprise a hole transport layer, an emission layer, and an electron transport layer.

15. The method as claimed in any of claims 12 to 14, wherein the electron injection layer is formed between the electron transport layer and the cathode.

16. The method as claimed in any of claims 12 to 15, wherein the actinide-containing layer comprises actinide fluoride, actinide chloride, actinide bromide, actinide oxide, actinide nitride, actinide sulfide, actinide carbonate, or combinations thereof.

17. The method as claimed in any of claims 12 to 16, wherein the lanthanide-containing layer comprises lanthanide fluoride, lanthanide chloride, lanthanide bromide, lanthanide oxide, lanthanide nitride, lanthanide sulfide, lanthanide carbonate, or combinations thereof.

18. The method as claimed in any of claims 12 to 17, wherein the electron injection layer comprises cerium halide, cerium nitride, cerium oxide, cerium sulfide, cerium oxyfluoride, cerium carbonate, or combinations thereof.

19. The method as claimed in any of claims 12 to 18, wherein the electron injection layer comprises CeF₃, CeF₄, or combinations thereof.
